# EUROPEAN PATENT APPLICATION

(11) **EP 4 513 562 A1**
(43) Date of publication of application: **26.02.2025**
(21) Application number: 24763054.4
(22) Date of filing: 23.02.2024
(51) Int. Cl.: H01L 27/085, H01L 21/762, H01L 29/06, H01L 27/04, H01L 27/06, H01L 27/02, H01L 21/335, H01L 21/82

(54) **LEVEL SHIFTER AND PREPARATION METHOD THEREFOR, AND SEMICONDUCTOR DEVICE AND PREPARATION METHOD THEREFOR**

(30) Priority: 01.03.2023 CN 202310182769; 15.06.2023 CN 202310715382
(71) Applicant: United Nova Technology - Xianfeng (Shaoxing) Corp., Shaoxing, Zhejiang 312000 (CN)
(72) Inventor: ZHAO, Liangliang, Shaoxing, Zhejiang 312000 (CN); LI, Yong, Shaoxing, Zhejiang 312000 (CN); GU, Xueqiang, Shaoxing, Zhejiang 312000 (CN); SUN, Wei, Shaoxing, Zhejiang 312000 (CN); WANG, Cong, Shaoxing, Zhejiang 312000 (CN)
(74) Representative: Kraus & Lederer PartGmbB
(86) International application number: PCT/CN2024/078244
(87) International publication number: WO 2024/179372

(57) **Abstract**

The present invention provides a level shifter, a semiconductor device, and preparation methods thereof. In the level shifter, a non-doped region and/or an inversion doped region are formed in at least one isolation doped region, so that an overall number of ions in the isolation doped region is reduced. This helps reduce difficulty of depleting the isolation doped region transversely and improve overall voltage withstanding performance of the level shifter. In this way, isolation performance of an isolation area can be ensured while a breakdown voltage of the level shifter is improved, and it is ensured that electrical leakage does not occur between a high-voltage side circuit and a drain.

## Description

### TECHNICAL FIELD

The present invention relates to the field of semiconductor technologies, and in particular, to a level shifter and a preparation method thereof, and a semiconductor device and a preparation method thereof.

### BACKGROUND

A high-voltage power gate driver chip is usually implemented by using a process integrating a high-voltage circuit and a low-voltage circuit. Between a high-voltage side circuit and a low-voltage side circuit, a control signal from the low-voltage side circuit is converted into a control signal of the high-voltage side circuit by a level shifter (Level Shifter), to transfer the control signal to the high-voltage side circuit, and control the high-voltage side circuit. In this way, level shift between the high-voltage side circuit and the low-voltage side circuit is implemented.

An isolation area is arranged on a periphery of the level shifter, to isolate the high-voltage side circuit from the level shifter, and prevent electrical leakage from affecting functions between devices. Currently, an isolation manner in the isolation area includes, for example, dielectric isolation (using an insulating medium such as an oxide to isolate device structures in a substrate), self-isolation (relying on voltage withstanding performance of depletion layers of devices to implement isolation between the devices), and junction isolation (using a principle of PN reverse bias to implement isolation). When the isolation area is designed, a sufficient dielectric withstand voltage of the isolation area needs to be ensured, to ensure isolation performance between the high-voltage side circuit and the level shifter, and in addition, voltage withstanding performance of the level shifter usually also needs to be considered.

Therefore, how to improve a breakdown voltage of the level shifter while ensuring voltage withstanding performance of the isolation area is always an important research topic in the field.

### SUMMARY

An objective of the present invention is to provide a level shifter and a preparation method thereof, to effectively increase a breakdown voltage of the level shifter, and optimize voltage withstanding performance of the device.

Therefore, the present invention provides a level shifter, including: a substrate; a field-effect transistor, including: a drain region of a first doping type and a source region of the first doping type that are formed in the substrate, and a gate structure formed on the substrate, the gate structure being located between the source region and the drain region; and at least one isolation doped region of a second doping type, the isolation doped region extending along a periphery of the field-effect transistor and being arranged on the periphery of the field-effect transistor, where a non-doped region and/or an inversion doped region are formed in the at least one isolation doped region.

The present invention further provides a semiconductor device, including the level shifter described above and a high-voltage side circuit, where the high-voltage side circuit is located on a side of the isolation doped region away from the field-effect transistor.

The present invention further provides a preparation method of a level shifter, including: forming a field-effect transistor on a substrate, the field-effect transistor including a drain region of a first doping type, a source region of the first doping type, and a gate structure, the drain region and the source region being formed in the substrate, and the gate structure being formed on the substrate and being located between the source region and the drain region. In addition, the preparation method of a level shifter further includes: forming at least one isolation doped region of a second doping type on a periphery of the field-effect transistor, where a non-doped region and/or an inversion doped region are further formed in the at least one isolation doped region.

The present invention further provides a preparation method of a semiconductor device, including the steps of the preparation method of a level shifter described above; or the preparation method of a semiconductor device includes: processing a substrate of the level shifter described above, to prepare the semiconductor device.

In the level shifter provided in the present invention, a non-doped region or an inversion doped region is further configured in at least one isolation doped region, to reduce an overall number of ions in the isolation doped region. This helps reduce difficulty of depleting the isolation doped region transversely and improve overall voltage withstanding performance of the level shifter. In this way, isolation performance and voltage withstanding performance of an isolation area can be ensured while a breakdown voltage of the level shifter is improved, and it is ensured that electrical leakage does not occur between a high-voltage side circuit and a drain.

### BRIEF DESCRIPTION OF THE DRAWINGS

FIG. 1 is a schematic structural diagram of a semiconductor device having a level shifter according to an embodiment of the present invention.
FIG. 2 is a schematic cross-sectional view of the semiconductor device having a level shifter shown in FIG. 1.
FIG. 3 to FIG. 5 are three other schematic structural diagrams of a semiconductor device having a level shifter according to an embodiment of the present invention.
FIG. 6 to FIG. 14 are schematic structural diagrams of a preparation process of a semiconductor device having a level shifter according to an embodiment of the present invention.
FIG. 15 and FIG. 16 are schematic structural diagrams of another preparation process of a semiconductor device having a level shifter according to an embodiment of the present invention.
FIG. 17 is a schematic structural diagram of a semiconductor device having a level shifter according to another embodiment of the present invention.
FIG. 18 is another schematic structural diagram of a semiconductor device having a level shifter according to another embodiment of the present invention.
FIG. 19 is a schematic cross-sectional view of a semiconductor device having a level shifter according to another embodiment of the present invention.
FIG. 20 is a partially enlarged view of an isolation doped region having an adjustment area according to another embodiment of the present invention.
FIG. 21 is a comparison diagram of simulated breakdown voltages when a drain end of a level shifter and a high-voltage side circuit are short-circuited in a case in which no adjustment area is provided in an isolation doped region and a case in which an adjustment area is provided in the isolation doped region.
FIG. 22 is a simulation diagram of a breakdown voltage between a drain end and a high-voltage side circuit of a level shifter in a working state when an adjustment area is provided.
FIG. 23 to FIG. 28 are schematic structural diagrams of a semiconductor device having a level shifter in a preparation process thereof according to another embodiment of the present invention.

### Reference numerals:

100-substrate; 110P-base; 120N-epitaxial layer; 200-field-effect transistor; 200S-source region; 200D-drain region; 200G-gate structure; 200B-first contact region; 210-second isolation oxide layer; 220-field oxide layer; 300-adjustment area; 310-isolation structure; 400-first isolation oxide layer; 510/520/530/540/550/560/570/580-mask layer; PBL1-first buried region; PBL2-second buried region; NBL1-third buried region; NBL2-fourth buried region; PBL3-fifth buried region; DPW1-first deep well region; DPW2-second deep well region; PW 1-first shallow well region; PW2-second shallow well region; NW1-third well region; and NW2-fourth well region.

### DETAILED DESCRIPTION

The following further describes in detail, with reference to the accompanying drawings and specific embodiments, a level shifter, a semiconductor device, and preparation methods thereof provided in the present invention. Advantages and features of the present invention will be clearer based on the following descriptions. It should be noted that, all the accompanying drawings are in an extremely simplified form and in an imprecise proportion, and are merely used for assisting in conveniently and clearly describing the embodiments of the present invention. It should be aware that, relative terms such as "above", "below", "top", "bottom", "upper", and "lower" shown in the accompanying drawings may be used for describing relationships between various elements. These relative terms are intended to cover different orientations of the elements in addition to the orientations depicted in the accompanying drawings. If an apparatus is inverted relative to a view in the accompanying drawings, for example, an element described as being "above" another element will now be below the element.

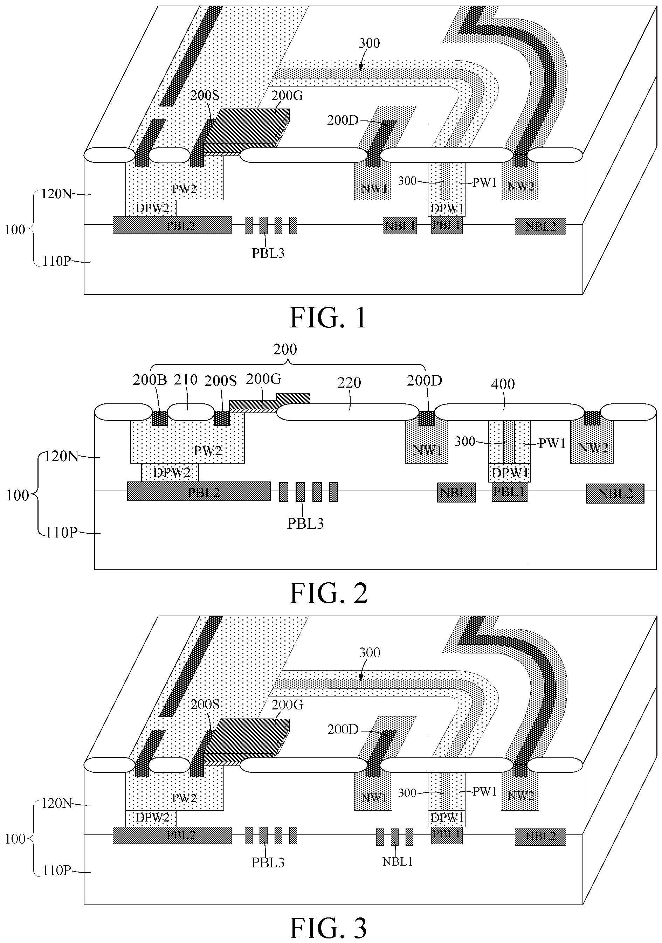

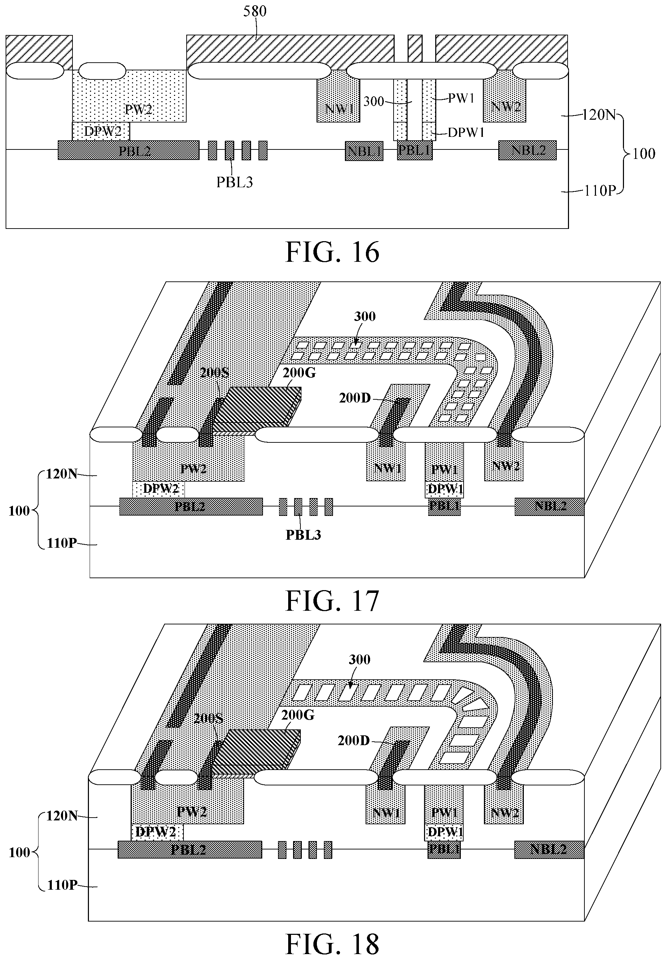

FIG. 1 is a schematic structural diagram of a semiconductor device having a level shifter according to an embodiment of the present invention. FIG. 2 is a schematic cross-sectional view of the semiconductor device shown in FIG. 1. FIG. 3 to FIG. 5 are three other schematic structural diagrams of a semiconductor device having a level shifter according to an embodiment of the present invention. FIG. 17 and FIG. 18 are two schematic structural diagrams of a semiconductor device having a level shifter according to another embodiment of the present invention.

With reference to FIG. 1 to FIG. 5/FIG. 17 and FIG. 18, the level shifter provided in this embodiment includes: a substrate 100, a field-effect transistor 200 formed on the substrate 100, and at least one isolation doped region formed on an outer side of the field-effect transistor 200 (for example, three isolation doped regions are included in this embodiment, which are respectively a first buried region PBL1, a first deep well region DPW1, and a first shallow well region PW1).

The substrate 100 has a doped layer of a first doping type (namely, an epitaxial layer 120N). In a specific example, the substrate 100 includes, for example, a base 110P and an epitaxial layer 120N formed on the base 110P. The base 110P is specifically a base of a second doping type, the epitaxial layer 120N is specifically an epitaxial layer of the first doping type. Therefore, the epitaxial layer 120N constitutes the doped layer of the first doping type in the substrate 100.

It should be noted that, the first doping type and the second doping type are opposite doping types. For example, if the first doping type is an N-type, the second doping type is a P-type; or if the first doping type is the P-type, the second doping type is the N-type. In this embodiment, an example in which the first doping type is the N-type and the second doping type is the P-type is used for description.

Further, the field-effect transistor 200 specifically includes a drain region 200D of the first doping type, a source region 200S of the first doping type, and a gate structure 200G. The drain region 200D and the source region 200S are specifically formed in the doped layer of the first doping type in the substrate 100 (namely, the epitaxial layer 120N), and the gate structure 200G is formed on the substrate 100 and located between the source region 200S and the drain region 200D. In this embodiment, the field-effect transistor 200 is, for example, an LDMOS transistor, and the epitaxial layer 120N located in a transistor area may be used to constitute a drift region of the LDMOS transistor.

Still referring to FIG. 1 to FIG. 5/FIG. 17 and FIG. 18, an isolation area is arranged on the outer side of the field-effect transistor 200, to isolate the field-effect transistor 200 form a high-voltage side circuit, and prevent electrical leakage from affecting functions between devices. At least one isolation doped region (for example, P-type isolation area) of the second doping type is arranged in the isolation area, and the isolation doped region extends along a periphery of the field-effect transistor. In an example, the isolation doped region may surround the transistor area from a high-voltage side of the transistor area (to be specific, a side near the drain region 200D) to a low-voltage side of the transistor area (to be specific, a side near the source region 200S). Specifically, the at least one isolation doped region is formed in the doped layer of the first doping type in the substrate 100, to implement device isolation by using a PN junction isolation technology. By performing PN reverse bias on a PN junction isolation, a depletion layer of the PN junction isolation structure can be expanded, to improve antibreakdown performance of the device and reduce electrical leakage between the field-effect transistor 200 and the high-voltage side circuit.

Further, at least two interconnected isolation doped regions are sequentially arranged in the isolation area from bottom to top, where an isolation doped region at a bottom layer extends upward from the base 110P into the epitaxial layer 120N, an isolation doped region at an upper layer is formed in the epitaxial layer 120N. In other words, the at least two isolation doped regions are sequentially connected from top to bottom, to run through the epitaxial layer 120N in a height direction and arrive at the base 110P.

In this embodiment, three isolation doped regions are arranged in the isolation area, including respectively a first buried region PBL1 of the second doping type, a first deep well region DPW1 of the second doping type, and a first shallow well region PW1 of the second doping type that are sequentially arranged from bottom to top and connected to each other. Herein, the first shallow well region PW1 is a well region whose doping depth is shallower than that of the first deep well region DPW1, and the first deep well region DPW1 is a well region whose doping depth is deeper than that of the first shallow well region PW1. Specifically, the first shallow well region PW1 extends inward from a top surface of the substrate 100 and partially coincides with the first deep well region DPW1 below in the height direction, the first deep well region DPW1 partially coincides with the first buried region PBL1 below in the height direction, and the first buried region PBL1 spans an interface between the epitaxial layer 120N and the base 110P, so that the first shallow well region PW1, the first deep well region DPW1, and the first buried region PBL1 are connected up and down and run through the epitaxial layer 120N.

It should be aware that, three isolation doped regions are provided in this embodiment, and in other examples, two isolation doped regions may be included (for example, only a first shallow well region PW1 and a first buried region PBL1 connected up and down are included), or three or more isolation doped regions may be included, provided that the isolation doped regions are sequentially connected to run through the epitaxial layer 120N.

In addition, a first isolation oxide layer 400 may be further arranged on an isolation doped region at a top layer, and the first isolation oxide layer 400 is formed on the top surface of the substrate 100 and is located above the isolation doped region. The first isolation oxide layer 400 may be formed, for example, by using a local oxidation of silicon (Local Oxidation of Silicon, LOCOS) process. When the substrate 100 is a silicon substrate, the first isolation oxide layer 310 may correspondingly be a silicon oxide layer.

A non-doped region and/or an inversion doped region of the first doping type are further provided in the at least one isolation doped region. For example, the non-doped region and/or the inversion doped region may be provided at least in the isolation doped region at the top layer, configured to adjust an overall ion doping amount of the isolation doped region, to reduce an overall number of ions in the isolation doped region. This helps reduce difficulty of depleting the isolation doped region transversely and increase a breakdown voltage of the level shifter.

In an embodiment of the present invention, referring to FIG. 1 to FIG. 5, when the non-doped region is provided, the non-doped region may continuously extend along the isolation doped region, so that the non-doped region correspondingly surrounds the outer side of the field-effect transistor 200; and when the inversion doped region is provided, the inversion doped region may also continuously extend along the isolation doped region, so that the inversion doped region correspondingly surrounds the field-effect transistor 200. The non-doped region and/or the inversion doped region provided in the present invention are arranged in the isolation doped region in a manner of continuously extending along an extending direction of the isolation doped region. Therefore, the non-doped region and the inversion doped region are easy to prepare, and a process is easier to control. This helps improve a product qualification rate, and is applicable to mass production.

In another embodiment of the present invention, referring to FIG. 17 and FIG. 18, a plurality of non-doped regions and/or a plurality of inversion doped regions may be arranged in the isolation doped region, and the plurality of non-doped regions and/or the plurality of inversion doped regions may be sequentially arranged in the isolation doped region at intervals along the extending direction of the isolation doped region. For example, referring to FIG. 17, the plurality of non-doped regions and/or a plurality of inversion doped regions are arranged in two rows, where non-doped regions and/or inversion doped regions in each row are sequentially arranged at intervals along the extending direction of the isolation doped region, that is, are arranged in an array; or as shown in FIG. 18, the plurality of non-doped regions and/or the plurality of inversion doped regions are arranged in a single row along the extending direction of the isolation doped region. It is clear that, in another example, the plurality of non-doped regions and/or the plurality of inversion doped regions may be arranged in another manner. This is not limited herein.

For ease of description, the following describes a case in which the non-doped region and the inversion doped region are both defined as adjustment areas 300. Therefore, for the non-doped region and the inversion doped region in this embodiment, refer to the adjustment area 300 shown in FIG. 1 to FIG. 5/FIG. 17 and FIG. 18.

For an adjustment area 300 of the inversion doped region, because a doping type of the inversion doped region is opposite to a doping type of the isolation doped region, this is equivalent to reducing an overall number of ions of the second doping type in the isolation doped region. The inversion doped region may be specifically formed by using an ion injection process, to be specific, ion injection of the first doping type is performed on the isolation doped region to form the inversion doped region. Alternatively, the inversion doped region may be formed by using a filled material of the first doping type, to be specific, the inversion doped region may include a groove formed in the isolation doped region and the material of the first doping type filled in the groove. Specifically, for example, the groove is at least one groove formed by performing ion injection on the substrate 100 to form the isolation doped region, and then etching a part of the isolation doped region. In this case, correspondingly, a P-doped region in the isolation doped region is partially removed, so that an overall doping amount in the isolation doped region is reduced (in other words, a number of P-type ions in the isolation doped region is reduced). In addition, the material of the first doping type is filled in the groove to form the inversion doped region, and this is equivalent to further reducing the overall number of P-type ions in the isolation doped region.

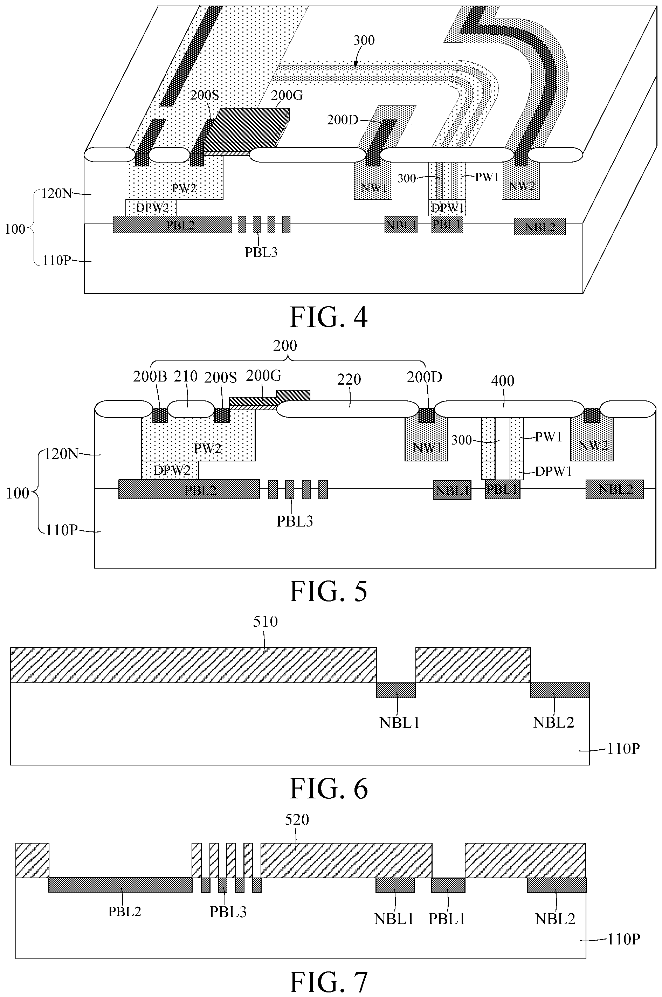

Further, a depth of the inversion doped region may be correspondingly adjusted according to a requirement, including: the inversion doped region may be formed only in the first shallow well region PW1 (for example, a depth of the adjustment area 300 in the examples in FIG. 1, FIG. 2, FIG. 3, and FIG. 4); or the inversion doped region may extend downward from the first shallow well region PW1 to the first deep well region DPW1 (for example, a depth of the adjustment area 300 in the example in FIG. 5); or the inversion doped region may be formed in the first shallow well region PW1 and first deep well region DPW1, and may further extend downward to the first buried region PBL1.

For an adjustment area 300 of the non-doped region, in an optional solution, for example, the non-doped region is an area on which ion injection is not performed in the ion injection process in the isolation doped region (to be specific, when ion injection is performed on the isolation doped region, a mask layer may be used to cover a part of the isolation area to avoid ion injection, to form the non-doped region). In this case, the overall doping amount in the isolation doped region can also be reduced (in other words, the number of P-type ions in the isolation doped region is reduced). In this embodiment, in at least one process in ion injection processes of the first shallow well region PW1, the first deep well region DPW1, and the first buried region PBL1, partial blocking is performed to form the non-doped region. In another optional solution, for example, the non-doped region includes: a groove formed in the isolation doped region and a non-doped material filled in the groove. Preparation technologies and groove depths of the groove for containing the non-doped material in this solution and the groove for containing the material of the first doping type in the foregoing solution may be set similarly. Details are not described herein again. In still another optional solution, the non-doped region may alternatively include only a groove formed in the isolation doped region.

Similarly, a depth of the non-doped region in the example may also be correspondingly adjusted according to a requirement, including: the non-doped region may be formed only in the first shallow well region PW1 (for example, the depth of the adjustment area 300 in the examples in FIG. 1, FIG. 2, FIG. 3, and FIG. 4); or the non-doped region may extend downward from the first shallow well region PW1 to the first deep well region DPW1 (for example, the depth of the adjustment area 300 in the example in FIG. 5); or the non-doped region may be formed in the first shallow well region PW1 and first deep well region DPW1, and may further extend downward to the first buried region PBL1.

In a further solution, for example, as shown in FIG. 4, at least two adjustment areas 300 may be arranged in the isolation doped region. In other words, at least two non-doped regions may be arranged in the isolation doped region, and the at least two non-doped regions are sequentially arranged in a direction from near to far relative to the field-effect transistor 200; or at least two inversion doped regions may be arranged in the isolation doped region, and the at least two inversion doped regions are sequentially arranged in the direction from near to far relative to the field-effect transistor 200. Both of the two adjustment areas 300 shown in FIG. 4 continuously extend along the isolation doped region, and sequentially surround the outer side of the field-effect transistor. Alternatively, at least one inversion doped region and at least one non-doped region are provided in the isolation doped region, and the at least one inversion doped region and the at least one non-doped region are sequentially arranged in a direction from near to far relative to the field-effect transistor 200 (not shown in the figure).

In other words, in the example in FIG. 4, at least two adjustment areas 300 are arranged in the isolation doped region, and each adjustment area 300 continuously extends along the isolation doped region, so that the at least two adjustment areas 300 sequentially surround the outer side of the field-effect transistor 200 from near to far. However, in the examples in FIG. 17 and FIG. 18, a plurality of adjustment areas 300 are arranged in the isolation doped region, and the plurality of adjustment areas 300 are arranged at intervals along the extending direction of the isolation doped region in a single row or a plurality of rows.

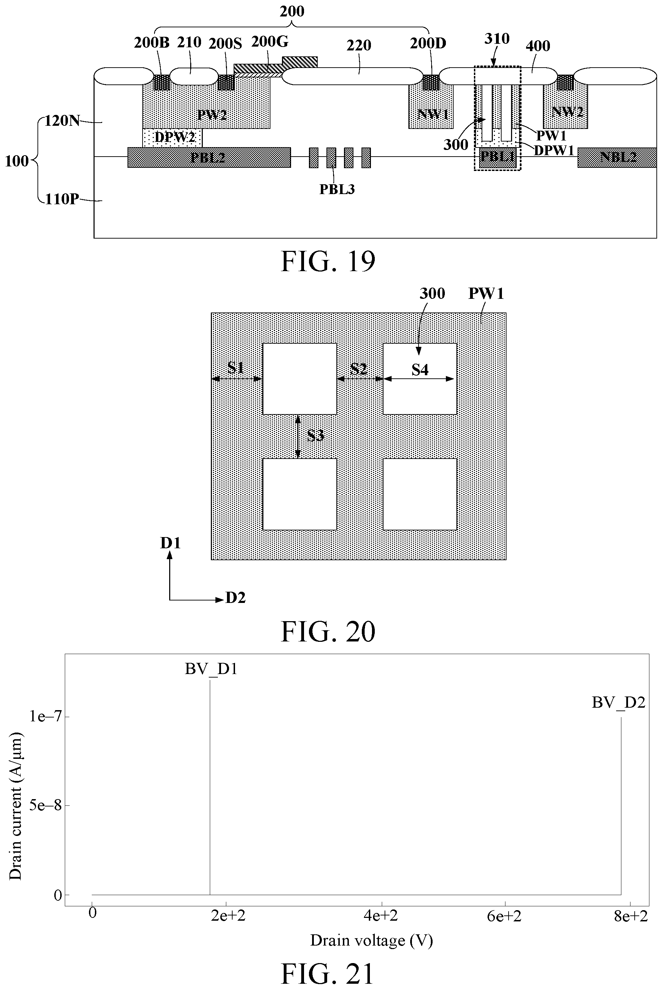

In addition, in the examples in FIG. 17 and FIG. 18, for parameter setting of the adjustment area 300, refer to FIG. 20 for details. In FIG. 20, a direction D1 is the extension direction of the isolation doped region, and a direction D2 is a direction of a cross section perpendicular to the extending direction of isolation doped region. A spacing S1 between the adjustment area 300 and an adjacent side edge of the isolation doped region is greater than or equal to 1 µm, and a spacing between adjacent adjustment areas 300 may also be greater than or equal to 1 µm (for example, a spacing S3 between adjacent adjustment areas 300 in the direction D1 is greater than or equal to 1 µm, and a spacing S2 between adjacent adjustment areas 300 in the direction D2 may also be greater than or equal to 1 µm). In addition, a cross-sectional shape of the adjustment area 300 parallel to the surface of the substrate may be circular, elliptical, rhombic, rectangular, or the like, and a maximum transverse dimension S4 of the adjustment area 300 is, for example, from 2 µm to 5 µm. It should be aware that, the shape and the size of the adjustment area 300, and the distance between the adjustment area 300 and the adjacent side edge of the isolation doped region are not limited thereto, and in a specific application, for example, may be adjusted correspondingly based on an actual doping concentration, a size, and the like of the isolation doped region.

Still referring to FIG. 1 to FIG. 5/FIG. 17 and FIG. 18, a second shallow well region PW2 of the second doping type is further formed in the substrate 100, the second shallow well region PW2 extends downward from the top surface of the substrate 100 into the substrate, the second shallow well region PW2 is formed on a low-voltage side of the transistor area (to be specific, formed on a side of the gate structure 200G near the source region 200S), and the source region 200S may be formed in the second shallow well region PW2. In addition, a part of the gate structure 200G near the source region 200S further covers the second shallow well region PW2. When a turn-on voltage is applied to the gate structure 200G of the field-effect transistor 200, a conductive channel is formed through inversion in the second shallow well region PW2 covered by the gate structure 200G, to implement current flow between the source region 200S, the conductive channel, a drift region, and the drain region 200D, in other words, the second shallow well region PW2 is configured to constitute a bulk region of an inversed type compared with a channel of the field-effect transistor 200.

A first contact region 200B (specifically, a bulk contact region Bulk) of the second doping type is further formed in the second shallow well region PW2, where an ion doping concentration of the first contact area 200B is greater than an ion doping concentration of the second shallow well region PW2, for electrically leading out the second shallow well region PW2 through the first contact region 200B. In this embodiment, the first contact region 200B is formed on a side of the source region 200S away from the gate structure 200G, and a second isolation oxide layer 210 is further arranged between the first contact region 200B and the source region 200S.

In a specific example, the second shallow well region PW2 and the first shallow well region PW1 may be formed simultaneously in a same ion injection process, so that the second shallow well region PW2 and the first shallow well region PW1 have the same parameters, in other words, doping depths and doping concentrations of the second shallow well region PW2 and the first shallow well region PW1 may be approximately the same. In particular, the first shallow well region PW1 may surround the field-effect transistor 200 from an outer side of the drain region 200D to horizontally extend to the low-voltage side of the transistor area, so that the first shallow well region PW1 is connected to the second shallow well region PW2 in a horizontal direction, and further, the first shallow well region PW1 and the second shallow well region PW2 connected to each other surround the field-effect transistor 200.

It should be noted that, because the second shallow well region PW2 and the first shallow well region PW1 are formed simultaneously in the same ion injection process, in this case, to ensure performance of the field-effect transistor 200, requirements on a doping concentration and a doping depth of the second shallow well region PW2 need to be satisfied, and consequently, it is difficult to directly adjust a doping concentration and a doping depth of the first shallow well region PW1 in the ion injection process. Based on this, in this embodiment, the adjustment area 300 (to be specific, the non-doped region or the inversion doped region) is provided, so that an overall ion doping amount of the first shallow well region PW1 can be greatly reduced without affecting the second shallow well region PW2. This helps reduce difficulty of depleting the isolation doped region transversely.

In this embodiment, a second deep well region DPW2 of the second doping type and a second buried region PBL2 of the second doping type is further formed in the substrate 100. The second deep well region DPW2 and the second buried region PBL2 are sequentially formed below the second shallow well region PW2 and are connected to each other, doping depths and doping concentrations of the second deep well region DPW2 and the first deep well region the DPW 1 may be the same, and doping depths and doping concentrations of the second buried region PBL2 and the first buried region PBL1 may be the same. Specifically, the second deep well region DPW2 and the first deep well region DPW1 may be formed simultaneously in a same ion injection process, and the second buried region PBL2 and the first buried region PBL1 may also be formed simultaneously in a same ion injection process. Specifically, the second shallow well region PW2 extends inward from the top surface of the substrate 100 and partially coincides with the second deep well region DPW2 below in the height direction, the second deep well region DPW2 partially coincides with the second buried region PBL2 below in the height direction, and the second buried region PBL2 extends downward from the epitaxial layer 120N to the base 110P, so that the second shallow well region PW2, the second deep well region DPW2, and the second buried region PBL2 are connected up and down and run through the epitaxial layer 120N. Similarly, alternatively, the first buried region PBL1 and the first deep well region DPW1 may surround the field-effect transistor 200 from the outer side of the drain region 200D to horizontally extend to the low-voltage side of the transistor area (to be specific, a side close to the source region 200S), so that the first deep well region DPW1 is connected to the second deep well region DPW2 in the horizontal direction, and the first buried region PBL1 is connected to the second buried region PBL2 in the horizontal direction. In this way, the first deep well region DPW1 and second deep well region DPW2 that are connect to each other, and the first buried region PBL1 and the second buried region PBL2 that are connected to each other all surround the field-effect transistor 200.

It may be considered as that, on the low-pressure side (to be specific, the side close to the source region 200S) of the transistor area, the second shallow well region PW2, the second deep well region DPW2, and the second buried region PBL2 that are connected up and down are also used for isolation, and are horizontally connected to the first shallow well region PW1, the first deep well region DPW1, and the first buried region PBL1 in the isolation area one to one, to isolate the field-effect transistor 200 inside, so that an isolation ring surrounding the field-effect transistor 200 is formed.

In other words, the isolation doped region in this embodiment may be adjusted correspondingly based on a doping situation on the low-voltage side. For example, on the low-voltage side (to be specific, the side close to the source region 200S), to satisfy a performance requirement of the field-effect transistor 200, the depth of the second shallow well region PW2 is designed to be small. In this case, the second deep well region DPW2 may be additionally provided, so that the second shallow well region PW2, the second deep well region DPW2, and the second buried region PBL2 that are connected up and down can reach the base 110P to implement isolation. In this case, the first shallow well region PW1, the first deep well region DPW1, and the first buried region PBL1 may be correspondingly arranged in the isolation area. On the contrary, when the depth of the second shallow well region PW2 is designed to be large, and the second shallow well region PW2 can be connected to the second buried region PBL2 below up and down, in this case, the second deep well region DPW2 can be omitted. In this case, in the isolation area, the first deep well region DPW1 may be correspondingly omitted, and only the first shallow well region PW1 and the first buried region PBL1 are provided.

Still referring to FIG. 1 to FIG. 5/FIG. 17 and FIG. 18, a third well region NW1 of the first doping type is further formed in the substrate 100. The third well region NW1 is located on a high-voltage side of the transistor area (in other words, located on a side of the gate structure 200G near the drain region 200D), and the drain region 200D is formed in the third well region NW1. An ion doping concentration of the third well region NW1 may be between an ion doping concentration of the drain region 200D and an ion doping concentration of the epitaxial layer 120N, so that the third well region NW1 can be used to form a buffer, to prevent a large change in the ion doping concentration directly between the drain region 200D and the epitaxial layer 120N. As described above, in an optional solution, the inversion doped region of the first doping type may be formed by using the ion injection process. In this case, the inversion doped region and the third well region NW1 may be simultaneously formed by using a same ion injection process, to simplify the process. In this way, a depth of the formed inversion doped region and a depth of the third well region NW1 are almost the same. For example, the depth of the adjustment area 300 and the depth of the third well region NW1 are almost the same in FIG. 1, FIG. 2, FIG. 3, and FIG. 4.

Still referring to FIG. 1 to FIG. 5, in an example, the substrate 100 is further provided with a third buried region NBL1 of the first doping type, and the third buried region NBL1 is located below the third well region NW1, so that the third buried region NBL1 and the third well region NW1 at least partially coincide in space. In this embodiment, the third buried region NBL1 further extends transversely toward the isolation doped region, so that the third buried region NBL1 partially exceeds a projection range of the third well region NW1. In other words, the third buried region NBL1 partially coincides with the third well region NW1 in space, and further has a part exceeding a coinciding area. The third buried region NBL1 is provided to adjust electric field distribution of a drain, so that electric field lines in a drain area are smoother, to increase a breakdown voltage of the drain. This can even enable the breakdown voltage of the drain to be greater than a breakdown voltage of the high-voltage side circuit. In this way, an electrostatic protection structure can be formed between the high-voltage side circuit and the low-voltage side circuit to release a current. Further, a part of the third buried region NBL1 is formed in the base 110P, and extends upward from the base 110P to the epitaxial layer 120N.

It should be noted that, in a specific example, the third buried region NBL1 may be provided or may not be provided. In addition, the third buried region NBL1 may be a continuous doped region, for example, as shown in the examples in FIG. 1, FIG. 2, FIG. 4, and FIG. 5; alternatively, in another example, the third buried region NBL1 may be a plurality of doped regions that are intermittently arranged, for example, as shown in the example in FIG. 3. In the example shown in FIG. 3, a continuous large-area doped region is cut into a plurality of small-area doped regions that are intermittently arranged, so that a number of ions of the first doping type in the third buried region NBL1 can be reduced, to further optimize voltage withstanding performance.

In an optional solution, a field oxide layer 220 is further formed on a surface of the substrate 100. The field oxide layer 220 is located between the second shallow well region PW2 and the drain region 200D, and the gate structure 200G further extends to cover the field oxide layer 220, to constitute a field plate structure. The field oxide layer 220 may be formed, for example, by using a local oxidation of silicon (Local Oxidation of Silicon, LOCOS) process. When the substrate 100 is a silicon substrate, the field oxide layer 220 may correspondingly be a silicon oxide layer. In this embodiment, the drain region 200D is formed between the field oxide layer 220 and the first isolation oxide layer 400. In addition, the field oxide layer 220, the first isolation oxide layer 400, and the second isolation oxide layer 210 may be formed simultaneously in a same process step using the local oxidation of silicon process.

Still referring to FIG. 1 to FIG. 5/FIG. 17 and FIG. 18, in an example, a plurality of fifth buried regions PBL3 that are arranged side by side are further formed on the substrate 100. The plurality of fifth buried regions PBL3 are arranged in the transistor area, and are specifically arranged between the source region 200S and the drain region 200D, and more specifically, may be arranged below the gate structure 200G and the field oxide layer 220. In addition, the fifth buried region PBL3 extends downward from the epitaxial layer 120N to the base 110P (or it may be considered as that, the fifth buried region PBL3 extends upward from the base 110P to the epitaxial layer 120N). The fifth buried region PBL3 is provided, to further increase a depletion degree of the drift region of the field-effect transistor 200 below the filed oxide layer 220 (in the epitaxial layer 120N). Moreover, the plurality of fifth buried regions PBL3 with small width sizes are arranged side by side (for example, a width size of the fifth buried region PBL3 may be less than that a width size of the first buried region PBL1). This can effectively prevent an ion concentration of the second doping type from being excessively high in this area.

In addition, the embodiments further provide a semiconductor device having the level shifter described above, and the semiconductor device further includes a high-voltage side circuit. Referring to FIG. 1 to FIG. 5/FIG. 17 and FIG. 18, the high-voltage side circuit is arranged on a high-voltage side of the level shifter (to be specific, a side near the drain region 200D) and is located on a side of the isolation doped region away from the field-effect transistor 200. The high-voltage side circuit includes a fourth well region NW2 of the first doping type, and a second contact region of the first doping type is further formed in the fourth well region NW2, to implement an electrical connection to the outside. In addition, the high-voltage side circuit further includes a fourth buried region NBL2 of the first doping type, and the fourth buried region NBL2 extends upward from the base 110P into the epitaxial layer 120N.

In this embodiment, a third buried region NBL1 and a fourth buried region NBL2 may be simultaneously formed on two sides of the isolation doped region by using a same ion injection process, to enable the third buried region NBL1 and the fourth buried region NBL2 to have same doping parameters (for example, doping depths and doping concentrations are almost the same). In an optional solution, for example, as shown in FIG. 3, a mask pattern corresponding to an ion injection process may be adjusted, so that the third buried region NBL1 is formed as a plurality of small-area doped regions arranged at intervals, and the fourth buried region NBL2 is formed as a continuously extending large-area doped region. In this way, a number of ions in the formed third buried region NBL1 is less than a number of ions in the fourth buried region NBL2 in the same ion injection process. Further, an area of coinciding space between the third buried region NBL1 and the third well region NW1 is smaller than an area of coinciding space between the fourth buried region NBL2 and the fourth well region NW2, so that voltage withstanding performance of the drain can be equal to or greater than voltage withstanding performance of the high-voltage side, and this helps form an electrostatic protection structure between the high-voltage side circuit and the low-voltage side circuit.

During operation of the semiconductor device, the bulk contact area Bulk (namely, the first contact region 200B) and the source region 200S are connected to a low-potential port, the gate structure 200G is connected to a working voltage (such as 25 V), and the drain region 200D and the high-voltage side circuit (for example, the second contact region in the fourth well region NW2) are connected to a high-potential port (where for example, 600 V is applied to the drain region 200D, and for example, 615 V is applied to the high-voltage side circuit). In this process, isolation between the drain region 200D and the high-voltage side circuit can be implemented by the isolation area.

As described above, the adjustment area 300 is arranged in the isolation doped region, to adjust the overall ion doping amount of the isolation doped region, and reduce the overall number of ions in the isolation doped region. This helps reduce difficulty of depleting the isolation doped region transversely, and further increases a breakdown voltage of the level shifter.

Referring to a group of simulation results shown in FIG. 21, a comparison diagram of breakdown voltages BV_D when a drain of the device and the high-voltage side circuit are short-circuited in a case in which the adjustment area 300 is provided in the isolation doped region and a case in which the adjustment area 300 is not provided in the isolation doped region (that is, comparison of overall voltage withstanding performance of the level shifter) is simulated. As shown in FIG. 21, a breakdown voltage BV_D1 when the adjustment area 300 is not provided is only 173.7 V. However, a breakdown voltage BV_D2 when the adjustment area 300 is provided can be increased to 674.5 V. This greatly improves the voltage withstanding performance of the device.

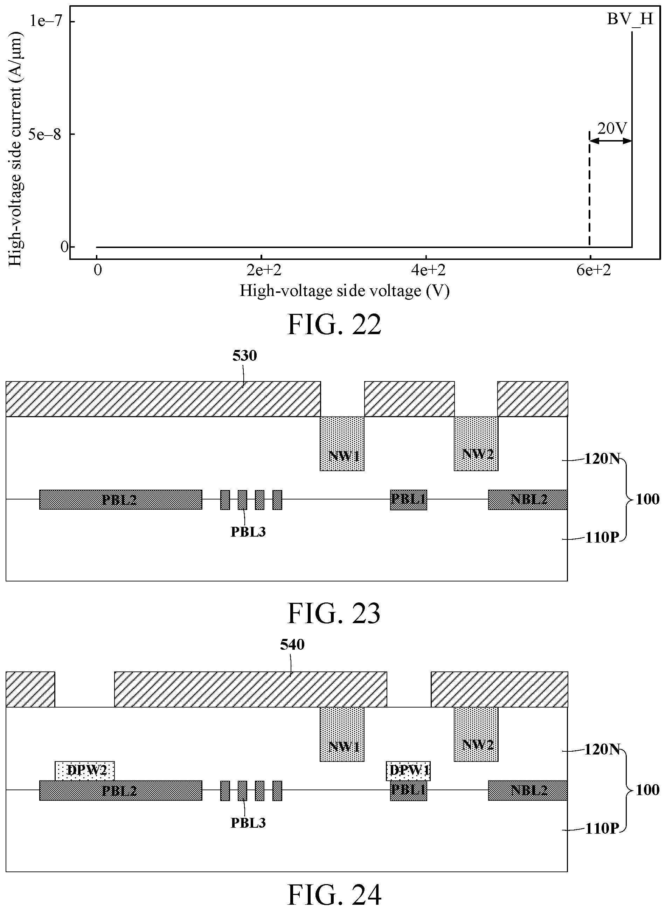

Next, referring to another simulation result shown in FIG. 22, a breakdown voltage BV_H between the high-voltage side circuit and the drain in a working state when the adjustment area 300 is provided is simulated. A manner of obtaining the breakdown voltage BV_H is, for example, keeping the drain region 200D connected to a potential of 600 V, and applying a scanning voltage gradually increasing from 600 V to the high-voltage side circuit (specifically, continuously increasing the scanning voltage starting from 600 V for the second contact region of the fourth well region NW4), until breakdown occurs. As shown in FIG. 22, when the adjustment area 300 is provided, the breakdown voltage BV_H between the high-voltage side circuit and the drain can be increased to 20 V, satisfying a voltage withstanding requirement (greater than 15 V) of an isolation structure 310, and thereby ensuring that there is no electrical leakage between the high-voltage side circuit and the drain.

For the level shifter and the semiconductor device described above, the following describes preparation methods thereof in detail. With reference to FIG. 1 to FIG. 5/FIG. 17 and FIG. 18, the preparation method of a level shifter in this embodiment specifically includes: forming a field-effect transistor 200 on a substrate 100. The field-effect transistor 200 includes a drain region 200D of a first doping type, a source region 200S of the first doping type, and a gate structure 200G, the drain region 200D and the source region 200S are formed in the substrate 100, and the gate structure 200G is formed on the substrate 100 and is located between the source region 200S and the drain region 200D. In addition, the preparation method of a level shifter further includes: forming at least one isolation doped region of a second doping type in the isolation area, and at least one non-doped region and/or at least one inversion doped region are further formed in the at least one isolation doped region. At least one non-doped region and/or at least one inversion doped region may continuously extend along the isolation doped region; or at least one non-doped region and/or at least one inversion doped region may be arranged at intervals in the isolation doped region along the extending direction of the isolation doped region. It is clear that, alternatively, a part of non-doped regions and/or inversion doped regions continuously extend along the isolation doped region, and meanwhile, a part of non-doped regions and/or inversion doped regions are sequentially arranged at intervals along the extending direction of the isolation doped region. In addition, for the semiconductor device, the preparation method thereof includes preparing the level shifter by using the method described above.

A method for forming the at least one isolation doped region in the isolation area may include: performing an ion injection process of the second doping type, to form a first shallow well region PW1. In a process of performing the ion injection process, a second shallow well region PW2 is also formed through injection at the same time. The second shallow well region PW2 is located on a side of the gate structure 200G near the source region 200S, the source region 200S is formed in the second shallow well region PW2, and the first shallow well region PW1 extends to the second shallow well region PW2 by surrounding the field-effect transistor 200 from an outer side of the drain region 200D to be connected to the second shallow well region PW2. As described above, a non-doped region and/or an inversion doped region are formed in the at least one isolation doped region.

A method of forming the inversion doped region in the isolation doped region includes, for example: performing an ion injection process of the first doping type on a part of area of the isolation area, to form the inversion doped region; and performing an ion injection process of the second doping type on the other part of area of the isolation area, to form the isolation doped region (including the first shallow well region PW1), where the isolation doped region surrounds the inversion doped region.

Alternatively, the method of forming the inversion doped region in the isolation doped region may be: forming a mask layer on the substrate 100, where the mask layer completely exposes the isolation area; then performing an ion injection process of the second doping type, to form the at least one isolation doped region (including the first shallow well region PW1); next, etching at least partial area in an isolation doped region at a top layer, to form a groove in the isolation doped region at the top layer; and then filling a material of the first doping type into the groove, to form the inversion doped region.

A method of forming the non-doped region in the isolation doped region includes, for example: forming a mask layer on the substrate 100, where the mask layer forms a blocking pattern on a part of an isolation area, to block the part of the isolation area, and expose the other part of the isolation area; and then performing an ion injection process of the second doping type, to form the isolation doped region (including the first shallow well region PW1) in the exposed isolation area, no ion being injected in the blocked part of the isolation area to form the non-doped region.

Alternatively, the method of forming the non-doped region in the isolation doped region may be: forming a mask layer on the substrate 100, where the mask layer completely exposes the isolation area; then performing an ion injection process of the second doping type, to form the at least one isolation doped region (including the first shallow well region PW1); next, etching at least partial area in an isolation doped region at a top layer, to form a groove in the isolation doped region at the top layer, and the groove part may constitute the non-doped region. In a further solution, alternatively, a material of the first doping type may be filled in the groove. In this case, it may be considered as that, the groove and the material of the first doping type filled in the groove constitute the non-doped region.

In a specific example, the isolation doped region at the top layer is the first shallow well region PW1, and a second shallow well region PW2 is also formed through injection when the first shallow well region PW1 is formed through injection. Based on this, doping depths and doping concentrations of the first shallow well region PW1 and the second shallow well region PW2 are the same or nearly the same. The inversion doped region or the non-doped region is formed in the first shallow well region PW1, so that a total number of P-type ions in the isolation area is reduced. It should be aware that, with a subsequent high-temperature process, the ions may perform inter-diffusion, causing an ion concentration of the first shallow well region PW1 to be reduced.

In a further solution, the substrate 100 has a doped layer of the first doping type. In this embodiment, the substrate 100 includes a base 110P and an epitaxial layer 120N formed on the base 110P. The base 110P is specifically a base of the second doping type, the epitaxial layer 120N is specifically an epitaxial layer of the first doping type. Therefore, the epitaxial layer 120N is a doped layer of the first doping type that constitutes the substrate 100.

In addition, at least two isolation doped regions (for example, P-type isolation doped regions) of the second doping type may be formed in the isolation area, the at least two isolation doped region are sequentially arranged from bottom to top and are connected to each other, and an isolation doped region at a bottom layer extends downward from the epitaxial layer 120N to the base 110P (which may also be considered as that, the isolation doped region at the bottom layer extends upward from the base 110P into the epitaxial layer 120N). In a specific example, the isolation doped region may alternatively surround a transistor area from a high-voltage side of the transistor area to extend to a low-voltage side of the transistor area. In this embodiment, three isolation doped regions are formed in the isolation area, and are respectively a first buried region PBL1 of the second doping type, a first deep well region DPW1 of the second doping type, and a first shallow well region PW1 of the second doping type that are sequentially connected to each other from bottom to top.

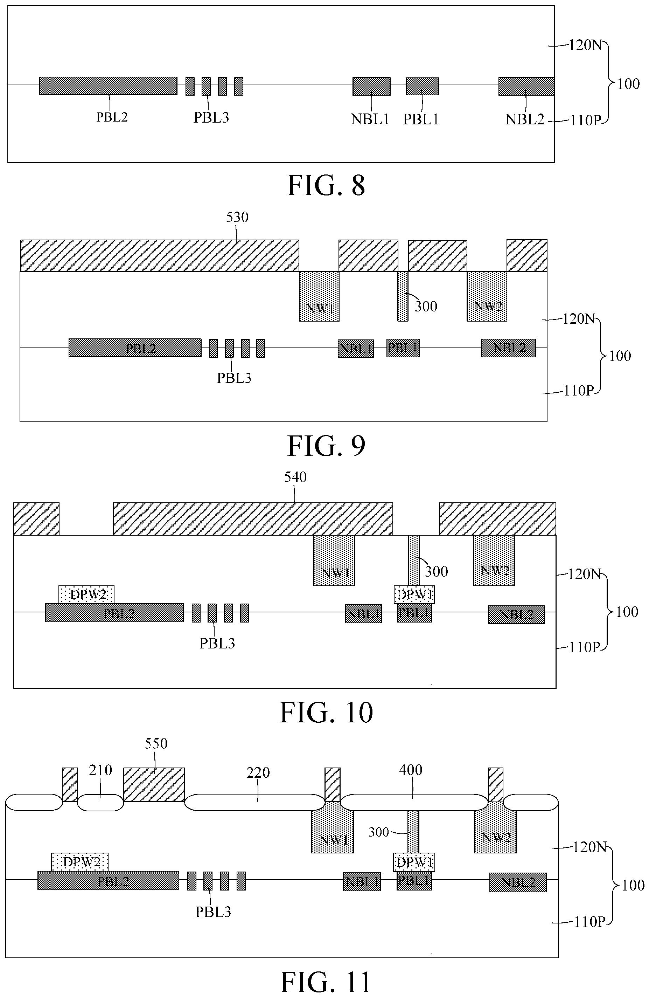

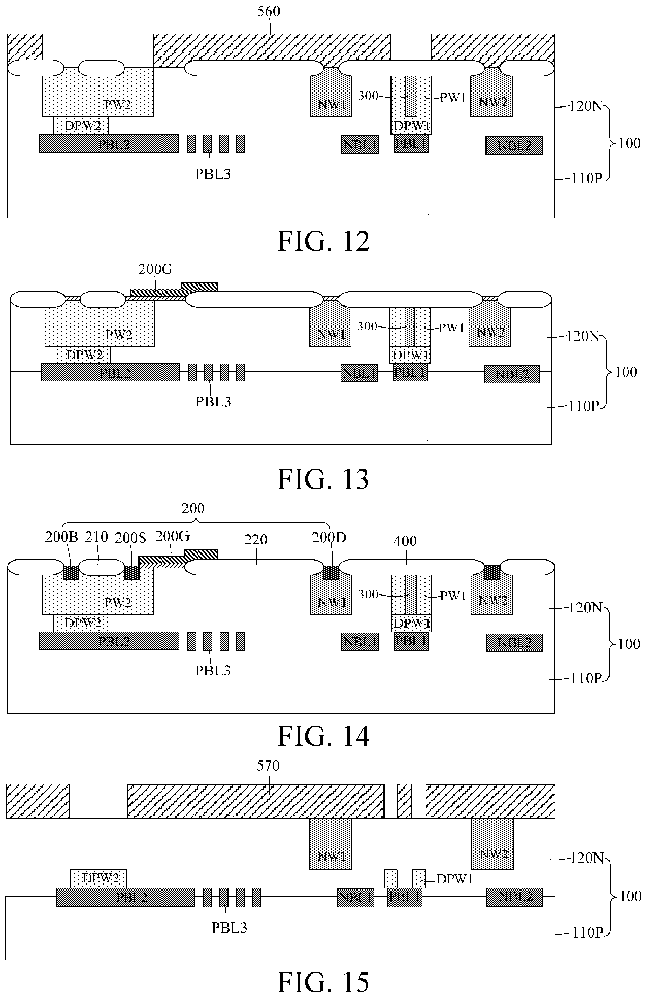

In an optional solution, for the method of forming at least one isolation doped region in the isolation area, refer to FIG. 7 to FIG. 10 and FIG. 12: First, referring to FIG. 7, a base 110P is provided, and before the epitaxial layer 120N is formed, a patterned mask layer 520 is formed on the base 110P; an ion injection process of the second doping type (for example, a P-type ion injection process) is performed on the base 110P under a mask of the mask layer 520, to form a first buried region PBL1; next, referring to FIG. 8, an epitaxy process is performed on the base 110P to form the epitaxial layer 120N, and when the epitaxial layer 120N is formed through epitaxy, ions in the first buried region PBL1 may further diffuse upward into the epitaxial layer 120N; then referring to FIG. 9, in this example, ion injection of the first doping type is performed on a part of the isolation area to form an inversion doped region (namely, an adjustment area 300 shown in FIG. 9); next, referring to FIG. 10, a patterned mask layer 540 is formed on the epitaxial layer 120N, and an ion injection process of the second doping type (for example, the P-type ion injection process) is performed on the epitaxial layer 120N under a mask of the mask layer 540, to form a first deep well region DPW1; and then referring to FIG. 12, a patterned mask layer 560 is formed on the epitaxial layer 120N, and then an ion injection process of the second doping type (for example, the P-type ion injection process) is performed under a mask of the mask layer 560 to form a first shallow well region PW1.

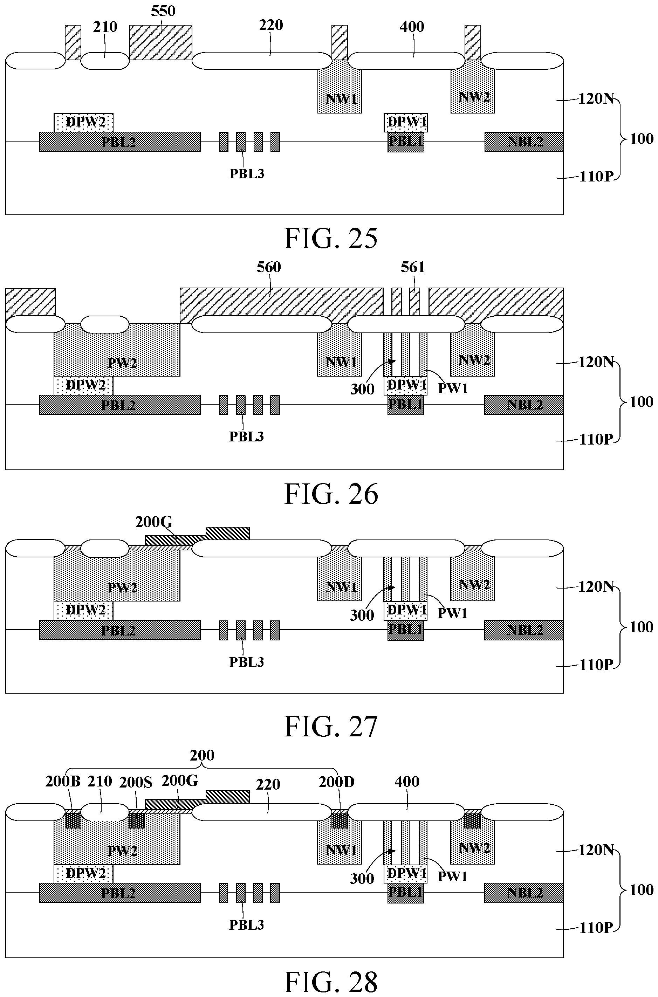

In another optional solution, for the method of forming at least one isolation doped region in the isolation area, alternatively, refer to FIG. 23 to FIG. 26: First, referring to FIG. 23, a base 110P is provided, and an ion injection process of the second doping type (for example, a P-type ion injection process) is performed on the base 110P, to form a first buried region PBL1; next, an epitaxy process is performed on the base 110P to form an epitaxial layer 120N, and when the epitaxial layer 120N is formed through epitaxy, ions in the first buried region PBL1 may further diffuse upward into the epitaxial layer 120N; then referring to FIG. 24, a patterned mask layer 540 is formed on the epitaxial layer 120N, and an ion injection process of the second doping type (for example, the P-type ion injection process) is performed on the epitaxial layer 120N under a mask of the mask layer 540, to form a first deep well region DPW1; and then referring to FIG. 26, a patterned mask layer 560 is formed on the epitaxial layer 120N, in this example, the mask layer 560 forms a blocking pattern 561 in an adjustment area 320 of an isolation structure, to merely expose partial area of the isolation structure, then an ion injection process of the second doping type (for example, the P-type ion injection process) is performed under a mask of the mask layer 560 to form a first shallow well region PW1, and ion injection is not performed in the area covered by the blocking pattern 561 in the first shallow well region PW1 to form a non-doped region.

In addition, when the first buried region PBL1, the first deep well region DPW1, and the first shallow well region PW1 in the isolation area are prepared, a second buried region PBL2, a second deep well region DPW2, and a second shallow well region PW2 are also correspondingly formed on a low-voltage side. The first buried region PBL1 and the second buried region PBL2 are connected to form an annular structure, the first deep well region DPW1 and the second deep well region DPW2 are connected to form an annular structure, and the first shallow well region PW1 and the second shallow well region PW2 are connected to form an annular structure, so that an annular isolation ring can be formed.

In an example, the preparation method of a level shifter further includes: preparing a first isolation oxide layer 400. For details, refer to FIG. 11/FIG. 25, and the first isolation oxide layer 400 may be formed by using a local oxidation of silicon process (LOCOS). In this embodiment, when the first isolation oxide layer 400 is prepared, a second isolation oxide layer 210 and a field oxide layer 220 are also formed.

The following describes a specific preparation method of a semiconductor device having a level shifter in detail with reference to FIG. 6 to FIG. 14. The specific preparation method includes a preparation process of the level shifter and a preparation process of another circuit (for example, a high-voltage side circuit).

First, referring to FIG. 6, a base 110P is provided, and the base 110P is a base of a second doping type. In this embodiment, the base 110P is a P-type base. The base 110P may be specifically doped with boron ions (B), and an ion concentration thereof is, for example, 1e13 cm⁻³ to 1.5e15 cm⁻³. Then, a mask layer 510 is formed on the base 110P, and an ion injection process of a first doping type (for example, an N-type ion injection process) is performed under a mask of the mask layer 510, to form a third buried region NBL1 on a high-voltage side of the level shifter (to be specific, a drain area of a field-effect transistor). In this embodiment, a fourth buried region NBL2 is further formed in an area of the high-voltage side circuit. Then, the mask layer 510 can be removed.

Then, referring to FIG. 7, a mask layer 520 is formed on the base 110P. The mask layer 520 defines a pattern of a first buried region PBL1 and a pattern of a second buried region PBL2, where the pattern of the first buried region PBL1 is located in an isolation area, the pattern of the second buried region PBL2 is located on a low-voltage side of a transistor area, and the first buried region PBL1 surrounds a periphery of the transistor area and is connected to the second buried region PBL2. Then, an ion injection process of the second doping type (for example, a P-type ion injection process) is performed under a mask of the mask layer 520, to form the first buried region PBL1 and the second buried region PBL2 in the base 110P. In this embodiment, a pattern of a fifth buried region PBL3 is further defined in the mask layer 520, the pattern of the fifth buried region PBL3 is located in the transistor area, so that when the ion injection process of the second doping type (for example, the P-type ion injection process) is performed, the fifth buried region PBL3 can be simultaneously formed in the transistor area.

In a specific example, the first buried region PBL1, the second buried region PBL2, and the fifth buried region PBL3 may be doped with boron, injection energy thereof is, for example, 20 keV to 100 keV, and an ion doping concentration thereof is, for example, 6e10 cm⁻³ to 6e14 cm⁻³.

Then, referring to FIG. 8, an epitaxial layer 120N is formed on the base 110P through epitaxy. When the epitaxial layer 120N is formed through epitaxy, ions in the first buried region PBL1, the second buried region PBL2, the third buried region NBL1, the fourth buried region NBL2, and the fifth buried region PBL3 may be enabled to diffuse upward from the base 110P into the epitaxial layer 120N. The epitaxial layer 120N is specifically an epitaxial layer of the first doping type, a thickness thereof is, for example, 4 µm to 9 µm; and the epitaxial layer 120N is, for example, doped with phosphorus, and a doping concentration thereof is, for example, 1e14 cm⁻³ to 1.6e16 cm⁻³.

Then, referring to FIG. 9, a mask layer 530 is formed on the epitaxial layer 120N. The mask layer 530 defines a pattern of a third well region, and may perform an ion injection process of the first doping type (for example, the N-type ion injection process) under a mask of the mask layer 530, to form the third well region NW1 in the epitaxial layer 120N. In this embodiment, a pattern of a fourth well region NW2 is further defined in the mask layer 530, the pattern of the fourth well region NW2 is located in the area of the high-voltage side circuit, so that when the ion injection process of the first doping type (for example, the N-type ion injection process) is performed, the fourth well region NW2 can be simultaneously formed in the area of the high-voltage side circuit. In a further solution, the mask layer 530 further defines a pattern of an inversion doped region in the isolation area. Therefore, when the ion injection process of the first doping type (for example, the N-type ion injection process) is performed, the inversion doped region can be simultaneously formed in the isolation area (namely, an adjustment area 300 shown in FIG. 9), where a doping depth of the inversion doped region may be close to or the same as a depth of the third well region NW1. Then, the mask layer 530 can be removed.

Then, referring to FIG. 10, a mask layer 540 is formed on the epitaxial layer 120N. The mask layer 540 defines a pattern of a first deep well region DPW1 and a pattern of a second deep well region DPW2, where the first deep well region DPW1 surrounds the periphery of the transistor area and is connected to the second deep well region DPW2. Then, an ion injection process of the second doping type (for example, the P-type ion injection process) may be performed under a mask of the mask layer 540, to form the first deep well region DPW1 and the second deep well region DPW2 in the epitaxial layer 120N. A bottom of the first deep well region DPW1 is connected to the first buried region PBL1 below the first deep well region DPW1, and a bottom of the second deep well region DPW2 is connected to the second buried region PBL2 below the second deep well region DPW2.

Then, referring to FIG. 11, a first isolation oxide layer 400 is formed on a surface of the epitaxial layer 120N. The first isolation oxide layer 400 is formed above the isolation doped region, and is used for enhancing isolation performance of the isolation area. The first isolation oxide layer 400 may be formed, for example, by using a local oxidation of silicon (Local Oxidation of Silicon, LOCOS) process. The process specifically includes: forming a mask layer 550 on the epitaxial layer 120N, then performing an oxidation process to form the first isolation oxide layer 400, and then the mask layer 550 can be removed. In this embodiment, when the first isolation oxide layer 400 is formed, a field oxide layer 220 and a second isolation oxide layer 210 are also formed.

Then, referring to FIG. 12, a mask layer 560 is formed on the epitaxial layer 120N. The mask layer 560 defines a pattern of a first shallow well region PW1 and a pattern of a second shallow well region PW2, where the first shallow well region PW1 surrounds the periphery of the transistor area and is connected to the second shallow well region PW2. Then, an ion injection process of the second doping type (for example, the P-type ion injection process) may be performed under a mask of the mask layer 560, to form the first shallow well region PW1 and the second shallow well region PW2 in the epitaxial layer 120N. In addition, a bottom of the first shallow well region PW1 is connected to the first deep well region DPW1 below the first shallow well region PW1, the first shallow well region PW1 further surrounds the inversion doped region, and a bottom of the second shallow well region PW2 is connected to the second deep well region DPW2 below the second shallow well region PW2. In this way, an isolation ring can be formed in the isolation area on the periphery of the transistor area, and the second shallow well region PW2 is further used for forming a bulk region of an inversed type compared with a channel of the field-effect transistor.

Then, referring to FIG. 13, an oxidation process is performed to form a gate oxide layer on the epitaxial layer 120N, and then a gate structure 200G is formed on the epitaxial layer 120N, where the gate structure 200G covers a part of the second shallow well region PW2. In this embodiment, the gate structure 200G further extends to cover the field oxide layer 220, to form a field plate structure, and to improve voltage withstanding performance of the device.

In a further solution, spacer(s) (not shown in the figure) may further be formed on side walls around the gate structure 200G. A preparation method of the spacer(s) specifically includes: depositing a spacer material, where the spacer material covers a top surface and the side walls around the gate structure 200G, and further covers a surface of a substrate in addition to the gate structure; next, an etching-back process is performed to remove the spacer material on a top surface of the gate structure, and remove the spacer material on a top surface of the substrate, so that the spacer material on the side walls around the gate structure 200G can be reserved to form the spacer(s).

Next, referring to FIG. 14, an ion injection process of the first doping type (for example, the N-type ion injection process) to form a source region 200S and a drain region 200D. The source region 200S is formed in the second shallow well region PW2, and the drain region 200D is formed in the third well region NW1. In this embodiment, a second contact region of the first doping type may also be simultaneously formed in the fourth well region NW2 in this step.

Still referring to FIG. 14, an ion injection process of the second doping type (for example, the P-type ion injection process) is performed to form a first contact region 200B, the first contact region 200B is formed in the second shallow well region PW2, and an ion doping concentration of the first contact region 200B is higher than an ion doping concentration of the second shallow well region PW2.

FIG. 6 to FIG. 14 schematically show the method of forming the inversion doped region of the first doping type in the isolation doped region by using the ion injection process. In the foregoing example, the inversion doped region is preferentially formed by using the ion injection process, and then the isolation doped region is formed through doping. However, in another example, the isolation doped region may alternatively be preferentially formed, and then the inversion doped region is formed through injection. In addition, the following describes a method of forming a non-doped region in the isolation doped region by using an example with reference to FIG. 15 and FIG. 16.

Specifically, referring to FIG. 15, a mask layer 570 is formed on the substrate 100. The mask layer 570 provides a blocking pattern on a part of the isolation area, so that the part of the isolation area is blocked, and the other part of the isolation area is exposed. In addition, an ion injection process of the second doping type is performed under a mask of the mask layer 570, to form a first deep well region DPW1. In this case, no ion is injected into the blocked part of the isolation area, so that a non-doped region is formed. Then, the mask layer 570 can be removed.

Then, still referring to FIG. 16, a mask layer 580 is formed on the substrate 100. The mask layer 580 also provides a blocking pattern on a part of the isolation area, so that the part of the isolation area is blocked, and the other part of the isolation area is exposed. In addition, an ion injection process of the second doping type is performed under a mask of the mask layer 580, to form a first shallow well region PW1. In this case, no ion is injected into the blocked part of the isolation area, so that a non-doped region is formed. In this embodiment, the first deep well region DPW1 and the first shallow well region PW1 may be arranged in alignment up and down, and the non-doped region in the first deep well region DPW1 and the non-doped region in the first shallow well region PW1 are arranged in alignment to form the non-doped region. Then, the mask layer 580 can be removed.

In other words, in the example shown in FIG. 15 and FIG. 16, the non-doped region is formed in the first shallow well region PW1 and the first deep well region DPW 1. However, in another example, the non-doped region may alternatively be formed only in the first shallow well region PW1.

It should be noted that, the preparation method of a semiconductor device shown in FIG. 6 to FIG. 14 and FIG. 15 and FIG. 16 specifically includes a preparation process of the level shifter and a preparation process of the high-voltage side circuit. However, in another example, when preparing the semiconductor device, the preparation process of the level shifter is not limited to the foregoing method (in other words, the level shifter may not be formed by using the foregoing method), provided that a structure of the level shifter described above can be prepared, and a preparation process of another circuit (for example, the high-voltage side circuit) may be combined on this basis. In other words, in another example, the preparation method of a semiconductor device includes processing a substrate of the level shifter described above to prepare the semiconductor device. This still falls within the protection scope of the technical solutions of the present invention.

It should be noted that the embodiments in this specification are described in a progressive manner. Description of each of the embodiments focuses on differences from other embodiments, and reference may be made to each other for the same or similar parts among embodiments. For any person skilled in the art, without departing from the scope of the technical solutions of the present invention, many possible changes and modifications may be made to the technical solutions of the present invention, or the technical solutions of the present invention may be modified into equivalent embodiments with equivalent changes by using the technical content disclosed above. Therefore, any simple modification, equivalent change and modification made for the foregoing embodiments according to the technical essence of the present invention without departing from the content of the technical solutions of the present invention shall still fall within the scope of the technical solutions of the present invention.

It should be further understood that, unless otherwise specified or indicated, descriptions such as "first", "second", and "third" in the specification are merely used to distinguish between components, elements, steps, and the like in the specification, but are not used to indicate a logical relationship, a sequential relationship, or the like between the components, elements, and steps. In addition, it should further be aware that, singular forms "a" and "an" used herein and in the appended claims include plural references, unless the context clearly indicates the contrary. For example, reference to "a step" or "an apparatus" means reference to one or more steps or apparatuses, and may include a secondary step and a secondary apparatus.

## Claims

1. A level shifter, comprising:
a substrate;
a field-effect transistor, comprising: a drain region of a first doping type and a source region of the first doping type that are formed in the substrate, and a gate structure formed on the substrate, the gate structure being located between the source region and the drain region; and
at least one isolation doped region of a second doping type, the isolation doped region extending along a periphery of the field-effect transistor and being arranged on the periphery of the field-effect transistor, wherein a non-doped region and/or an inversion doped region are formed in the at least one isolation doped region.

2. The level shifter according to claim 1, wherein the non-doped region is an area in which ion injection is not performed in an ion injection process in the isolation doped region.

3. The level shifter according to claim 1, wherein the non-doped region comprises a groove formed in the isolation doped region.

4. The level shifter according to claim 3, wherein the non-doped region further comprises a non-doped material filled in the groove.

5. The level shifter according to claim 1, wherein the inversion doped region is an area formed by performing ion injection of the first doping type using an ion injection process; or the inversion doped region comprises a groove formed in the isolation doped region and a material of the first doping type filled in the groove.

6. The level shifter according to claim 1, wherein the non-doped region continuously extends along the isolation doped region; and/or the inversion doped region is of the first doping type and continuously extends along the isolation doped region.

7. The level shifter according to claim 6, wherein at least two non-doped regions are provided in the isolation doped region, and the at least two non-doped regions are sequentially arranged in a direction from near to far relative to the field-effect transistor; or
at least two inversion doped regions are provided in the isolation doped region, and the at least two inversion doped regions are sequentially arranged in a direction from near to far relative to the field-effect transistor; or
at least one inversion doped region and at least one non-doped region are provided in the isolation doped region, and the at least one inversion doped region and the at least one non-doped region are sequentially arranged in a direction from near to far relative to the field-effect transistor.

8. The level shifter according to claim 1, wherein there are a plurality of non-doped regions and/or a plurality of inversion doped regions in the isolation doped region, and the plurality of non-doped regions and/or the plurality of inversion doped regions are sequentially arranged in the isolation doped region along an extending direction of the isolation doped region.

9. The level shifter according to claim 8, wherein an arrangement manner of the plurality of non-doped regions and/or the plurality of inversion doped regions in the isolation doped region comprises a manner of being arranged at intervals, to be specific, being arranged in an array.

10. The level shifter according to claim 1, wherein the substrate comprises a base of the second doping type and an epitaxial layer of the first doping type that are sequentially arranged from bottom to top, and the field-effect transistor is formed on the epitaxial layer; and
the level shifter comprises at least two interconnected isolation doped regions that are sequentially arranged from bottom to top, wherein an isolation doped region at a bottom layer extends upward from the base into the epitaxial layer.

11. The level shifter according to claim 10, wherein the at least two isolation doped regions comprise a first shallow well region of the second doping type that extends inward from a top surface of the epitaxial layer into the epitaxial layer; and
the level shifter further comprises a second shallow well region of the second doping type that extends inward from the top surface of the epitaxial layer into the epitaxial layer, the second shallow well region is located on a side of the gate structure near the source region, the source region is formed in the second shallow well region, and the first shallow well region extends to the second shallow well region by surrounding the field-effect transistor from an outer side of the drain region to be connected to the second shallow well region.

12. The level shifter according to claim 11, wherein the at least two isolation doped regions further comprise a first deep well region of the second doping type and a first buried region of the second doping type that are sequentially connected from top to bottom below the first shallow well region; and
the level shifter further comprises a second deep well region of the second doping type and a second buried region of the second doping type that are sequentially connected from top to bottom below the second shallow well region, the first deep well region extends to the second deep well region by surrounding the field-effect transistor from the outer side of the drain region to be connected to the second deep well region, and the first buried region extends to the second buried region by surrounding the field-effect transistor from the outer side of the drain region to be connected to the second buried region.

13. The level shifter according to claim 12, wherein the inversion doped region is formed only in the first shallow well region; or the inversion doped region extends downward from the first shallow well region to the first deep well region; or the inversion doped region extends downward from the first shallow well region sequentially to the first deep well region and the first buried region; and
the non-doped region is formed only in the first shallow well region; or the non-doped region extends downward from the first shallow well region to the first deep well region; or the non-doped region extends downward from the first shallow well region sequentially to the first deep well region and the first buried region.

14. The level shifter according to claim 1, wherein the level shifter further comprises a third well region of the first doping type, the third well region is located on a side of the gate structure near the drain region, and the drain region is formed in the third well region.

15. The level shifter according to claim 14, wherein the level shifter further comprises a third buried region of the first doping type, and the third buried region is arranged below the third well region.

16. The level shifter according to claim 15, wherein the third buried region is a doped region that continuously extends; or the third buried region comprises a plurality of doped regions arranged at intervals.

17. A semiconductor device, comprising the level shifter according to any one of claims 1 to 16 and a high-voltage side circuit, wherein the high-voltage side circuit is located on a side of the isolation doped region away from the field-effect transistor.

18. The semiconductor device according to claim 17, wherein the high-voltage side circuit comprises a fourth well region of the first doping type and a fourth buried region, the fourth buried region is arranged below the fourth well region and extends upward from the base to the epitaxial layer.

19. The semiconductor device according to claim 18, wherein the level shifter further comprises the third well region of the first doping type and the third buried region of the first doping type, the third well region is located on the side of the gate structure near the drain region, the drain region is formed in the third well region, and the third buried region is arranged below the third well region; and
an area of overlapping space between the third buried region and the third well region is less than an area of overlapping space between the fourth buried region and the fourth well region.

20. A preparation method of a level shifter, comprising: forming a field-effect transistor on a substrate, the field-effect transistor comprising a drain region of a first doping type, a source region of the first doping type, and a gate structure, the drain region and the source region being formed in the substrate, and the gate structure being formed on the substrate and being located between the source region and the drain region; and
the preparation method of a level shifter further comprising: forming at least one isolation doped region of a second doping type on a periphery of the field-effect transistor, wherein a non-doped region and/or an inversion doped region are further formed in the at least one isolation doped region.

21. The preparation method of a level shifter according to claim 20, wherein a preparation method of the at least one isolation doped region comprises:
forming a mask layer on the substrate, the mask layer completely exposing an isolation area;
performing an ion injection process of the second doping type, to form the at least one isolation doped region; and
etching at least partial area in an isolation doped region at a top layer, to form a groove in the isolation doped region at the top layer.

22. The preparation method of a level shifter according to claim 21, wherein after forming the groove, the method further comprises: filling a non-doped material into the groove to form the non-doped region; or filling a material of the first doping type into the groove to form the inversion doped region.

23. The preparation method of a level shifter according to claim 20, wherein a preparation method of the at least one isolation doped region comprises:
forming a mask layer on the substrate, the mask layer forming a blocking pattern on a part of an isolation area, to enable the part of the isolation area to be blocked, and enable the other part of the isolation area to be exposed; and
performing an ion injection process of the second doping type to form the isolation doped region, no ion being injected in the blocked part of the isolation area to form the non-doped region.

24. The preparation method of a level shifter according to claim 20, wherein the non-doped region continuously extends along the isolation doped region; and/or the inversion doped region is of the first doping type and continuously extends along the isolation doped region.

25. The preparation method of a level shifter according to claim 24, wherein at least two non-doped regions sequentially arranged in a direction from near to far relative to the field-effect transistor are formed in the isolation doped region; or
at least two inversion doped regions sequentially arranged in a direction from near to far relative to the field-effect transistor are formed in the isolation doped region; or
at least one inversion doped region and at least one non-doped region are formed in the isolation doped region, and are sequentially arranged in a direction from near to far relative to the field-effect transistor.

26. The preparation method of a level shifter according to claim 20, wherein a plurality of non-doped regions and/or a plurality of inversion doped regions are formed in the isolation doped region, and the plurality of non-doped regions and/or the plurality of inversion doped regions are sequentially arranged in the isolation doped region along an extending direction of the isolation doped region.

27. The preparation method of a level shifter according to claim 26, wherein an arrangement manner of the plurality of non-doped regions and/or the plurality of inversion doped regions in the isolation doped region comprises a manner of being arranged at intervals, to be specific, being arranged in an array.

28. The preparation method of a level shifter according to claim 20, wherein a forming method of the inversion doped region comprises: performing ion injection of the first doping type using an ion injection process to form the inversion doped region.

29. The preparation method of a level shifter according to claim 20, wherein a preparation method of the at least one isolation doped region comprises: performing an ion injection process of the second doping type, to form a first shallow well region; and
during the ion injection process, forming a second shallow well region through injection at the same time, the second shallow well region being located on a side of the gate structure near the source region, the source region being formed in the second shallow well region, and the first shallow well region extending to the second shallow well region by surrounding the field-effect transistor from an outer side of the drain region to be connected to the second shallow well region.

30. The preparation method of a level shifter according to claim 20, wherein the substrate comprising a base of the second doping type and an epitaxial layer of the first doping type that are sequentially arranged from bottom to top, and a preparation method of the at least one isolation doped region comprises:
before forming the epitaxial layer, performing an ion injection process of the second doping type on the base, to form a first buried region of the second doping type in the base; and
during an epitaxy process to form the epitaxial layer on the base, ions diffusing from the first buried region upward into the epitaxial layer, and performing the ion injection process of the second doping type twice on the epitaxial layer, to sequentially form a first deep well region and a first shallow well region, a bottom of the first deep well region being connected to the first buried region, and a bottom of the first shallow well region being connected to the first deep well region.

31. The preparation method of a level shifter according to claim 30, wherein when the first buried region is prepared, a second buried region is further formed on a low-voltage side of a transistor area, and the first buried region extends to the low-voltage side of the transistor area by surrounding the transistor area from a high-voltage side of the transistor area to be connected to the second buried region;
when the first deep well region is prepared, a second deep well region is further formed on the low-voltage side of the transistor area, and the first deep well region extends to the low-voltage side of the transistor area by surrounding the transistor area from the high-voltage side of the transistor area to be connected to the second deep well region; and
when the first shallow well region is prepared, a second shallow well region is further formed on the low-voltage side of the transistor area, and the first shallow well region extends to the low-voltage side of the transistor area by surrounding the transistor area from the high-voltage side of the transistor area to be connected to the second shallow well region.

32. The preparation method of a level shifter according to claim 30, wherein before forming the epitaxial layer, the method further comprises: performing an ion injection process of the first doping type on the base, to form a third buried region of the first doping type in the base, the third buried region being located in a drain area of the level shifter; and
in a process of performing the epitaxy process to form the epitaxial layer on the base, ions diffusing from the third buried region upward into the epitaxial layer.

33. A preparation method of a semiconductor device, comprising steps of the preparation method of a level shifter according to any one of claims 20 to 32; or
comprising: processing a substrate of the level shifter according to any one of claims 1 to 16, to prepare the semiconductor device.
